(19) Europäisches Patentamt
European Patent Office
Office européen des brevets

(11) **EP 1 003 030 A2**

(12) **EUROPÄISCHE PATENTANMELDUNG**

(43) Veröffentlichungstag:
24.05.2000 Patentblatt 2000/21

(51) Int. Cl.$^7$: **G01N 27/12**, H01L 35/00

(21) Anmeldenummer: **99118454.0**

(22) Anmeldetag: **17.09.1999**

(84) Benannte Vertragsstaaten:
**AT BE CH CY DE DK ES FI FR GB GR IE IT LI LU MC NL PT SE**
Benannte Erstreckungsstaaten:
**AL LT LV MK RO SI**

(30) Priorität: **20.11.1998 DE 19853595**

(71) Anmelder: **DORNIER GmbH**
**88039 Friedrichshafen (DE)**

(72) Erfinder: **Moos, Ralf**
**88048 Friedrichshafen (DE)**

(74) Vertreter: **Meel, Thomas**
**Dornier GmbH**
**L H G**
**88039 Friedrichshafen (DE)**

(54) **Verfahren und Messwandler zur Detektion des Sauerstoffgehaltes in einem Gas**

(57)    Die Erfindung betrifft ein Verfahren zur Detektion der Sauerstoffkonzentration in einem Gas, wobei

- ein schicht- oder folienartiger Funktionswerkstoff aus einem halbleitenden Metalloxid, dessen Thermokraft sich als Funktion des Sauerstoffpartialdrucks darstellen läßt, mit dem zu analysierenden Gas beaufschlagt wird;
- zwischen zwei Stellen des Funktionswerkstoffs eine Temperaturdifferenz erzeugt wird;
- die Spannungsdifferenz zwischen den beiden auf unterschiedlichen Temperaturen befindlichen Stellen des Funktionswerkstoffs gemessen wird, welche ein Maß für die Sauerstoffkonzentration darstellt.

Ein vorteilhafter Meßwandler zur Durchführung des erfindungsgemäßen Verfahrens sowie ein Verfahren zur Herstellung des Meßwandlers sind ebenfalls Gegenstand der Anmeldung.

Fig. 3

EP 1 003 030 A2

## Beschreibung

Die Erfindung betrifft ein Verfahren sowie einen Meßwandler zur Detektion des Sauerstoffgehaltes in einem Gas.

Immer schärfere Abgasgrenzwerte verbunden mit dem Druck zur Reduzierung des Kraftstoffverbrauches zwingen die Automobilhersteller zu neuen Konzepten für Verbrennungskraftmaschinen. Es zeigt sich, daß die beiden o.g. Forderungen am besten bei einem Betrieb mit Luftüberschuß (Luftzahl $\lambda > 1$) miteinander in Einklang gebracht werden können. Derartige moderne "Magerkonzepte" erfordern eine präzise Kenntnis des Sauerstoffgehaltes des Abgases. Das Prinzip der herkömmlichen potentiometrischen $\lambda$-Sonde kann nur mit großem Aufwand für hohe Sauerstoffkonzentrationen, wie sie in solch magerem Abgas vorkommen, ausgelegt werden.

Um auch im mageren Bereich den Sauerstoffgehalt des Abgases messen zu können, wurde vorgeschlagen, amperometrische Sonden nach dem Grenzstromprinzip ("Grenzstromsonde") aus einem sauerstoffionenleitenden Werkstoff aufzubauen, z.B. [1], DE 44 47 033, DE 44 08 361, DE 43 91 637 oder DE 27 11 880. Es besteht aber auch die Möglichkeit, die Sauerstoffpartialdruckabhängigkeit der elektrischen Leitfähigkeit eines metalloxidischen Werkstoffes als Sensoreffekt auszunutzen (z.B. [2-5]) und daraus einen Sensor herzustellen, aus dessen elektrischem Widerstand R auf den Sauerstoffpartialdruck pO2 des Abgases und daraus auf den Sauerstoffgehalt im Abgas geschlossen werden kann. Besonders gründlich wurden dotiertes Titanoxid ($TiO_2$) und Strontiumtitanat ($SrTiO_3$) untersucht, da solche Titanoxide aufgrund ihrer chemischen Stabilität den rauhen Betriebsbedingungen im Abgasstrang eines Verbrennungsmotors standhalten können. Jedoch besitzen Sensoren, aufgebaut aus diesen Verbindungen, -wie auch aus den meisten anderen Metalloxiden-, eine sehr starke Temperaturabhängigkeit des elektrischen Widerstandes, die eine aufwendige Heizungsregelung verbunden mit umfangreichen konstruktiven Maßnahmen, welche die Einflüsse plötzlicher Temperaturänderungen abmildern, erfordert.

Daher wurde erwogen, auf Kuprate (z.B. $La_2CuO_{4+\delta}$ überzugehen (DE 42 02 146, DE 42 44 723, DE 43 25 183, [6]), da deren elektrische Leitfähigkeit gerade im Bereich hoher Sauerstoffgehalte, d.h. bei $\lambda > 1$, von der Temperatur unabhängig ist. Für Anwendungen im Abgasstrang sind Kuprate aber nicht geeignet, da sie chemisch nicht allzu stabil sind und sich bei hohen Temperaturen und/oder bei niedrigen Sauerstoffpartialdrücken (z.B. kurzzeitiger Betrieb mit "fettem" Gemisch, ($\lambda < 1$)) zersetzen.

Chemisch wesentlich stabiler als Kuprate sind mit Erdalkalien dotierte Lanthanferrite (DE 44 18 054). Ihre elektrische Leitfähigkeit weist im Vergleich zu $SrTiO_3$ auch eine geringere Temperaturabhängigkeit im mageren Abgasbereich ($\lambda > 1$) auf. Allerdings besitzen Sensoren, welche aus diesen Materialien hergestellt wurden, eine größere Temperaturabhängigkeit des elektrischen Widerstandes als Sensoren auf Kupratbasis.

In der EP 0 062 994 wird vorgeschlagen, im $SrTiO_3$ das Titan (Ti) teilweise durch Eisen (Fe) zu ersetzen. Sensoren hergestellt aus der Verbindung $SrTi_{0,7}Fe_{0,3}O_{3-\delta}$ in mageren Atmosphären oberhalb 500°C..600°C besitzen eine wesentlich geringere Temperaturabhängigkeit des elektrischen Widerstandes aber eine Sauerstoffpartialdruckabhängigkeit gemäß $R \sim pO_2^{-1/5}$.

Zweckmäßigerweise werden solche resistiven Sauerstoffsensoren in Dickschichttechnik gefertigt, d.h. auf ein elektrisch nichtleitendes Substrat wird beispielsweise auf der einen Flachseite eine Heizwiderstandsschicht und auf der anderen Flachseite wird die sensitive Funktionsschicht und evtl. ein Temperaturmeßwiderstand aufgebracht. Die beschriebene Sensoranordnung wird in einem Schutzgehäuse angeordnet und mit einer Zuleitung versehen.

Das resistive Prinzip hat den Vorteil, daß mit einer einfachen Widerstandsmessung der Sauerstoffgehalt eines Gases gemessen werden kann. Dem steht jedoch der Nachteil gegenüber, daß in die Widerstandsmessung nicht nur die Materialeigenschaften in Form des spezifischen elektrischen Widerstandes, sondern auch die Geometrie der sensitiven Funktionsschicht eingeht. Zwar können Breite und Länge einer Schicht gut und reproduzierbar gefertigt werden. Jedoch ist eine genau reproduzierbar herzustellende Schichtdicke nur mit erheblichem prozeßtechnischem Aufwand realisierbar. Eine weitere Schwierigkeit ergibt sich, wenn solche Sensoren in rauhen Umgebungsatmosphären, wie sie z.B. im Abgasstrang eines Automobils oder eines Kraftwerkes vorherrschen, betrieben werden. Aufgrund von Abrasion oder anderer mechanischer Einflüsse, wie z.B. mikroskopisch kleiner Abplatzungen, ergibt sich eine Veränderung der Geometrie der Schicht, so daß sich die Sensorkennlinie mit der Zeit verändert.

Ein weiterer großer Nachteil liegt in der Morphologie der sensitiven Schichten begründet. Solche, i.A. polykristalline Funktionsschichten weisen Kornrandschichten auf, die sich elektrisch anders als das Korninnere verhalten. Dieses Phänomen wird sogar als Meßeffekt ausgenutzt, z.B. beim aus $SnO_2$-Schichten aufgebauten Gassensor [7,8]. Im Betrieb führt eine sich verändernde Korngrenzschicht zu einem unerwünschten Drift der Sensorkennlinie und teilweise auch zu Empfindlichkeitsverlusten.

Insbesondere um im Magerbereich sehr genau messen zu können, muß an der sensitiven Funktionsschicht in Vierdrahttechnik gemessen werden, da nur auf diese Weise Übergangswiderstände zwischen Elektrode und Funktionsschicht herausgerechnet werden können. Dies ist wichtig, da sich diese Übergangswiderstände üblicherweise ebenfalls mit dem Sauerstoffpartialdruck der Gasatmosphäre verändern. Dadurch sind weitere, teure elektrische Anschlußverbindungen nötig.

Noch einfacher als ein elektrischer Widerstand läßt sich eine elektrische Spannung messen, wie dies z.B. bei einem einfachen Grenzstromsensor der Fall ist. Allerdings geht dort die Diffusionskonstante der Diffusionsöffnung -also wiederum ein temperatur- und materialabhängiger Parameter- in das Meßsignal mit ein. Zudem ist der Aufbau eines solchen Sensors nicht einfach und aufgrund der aufwendigen Mehrlagentechnik sehr teuer.

Der Erfindung liegt die Aufgabe zugrunde, ein Meßverfahren sowie einen Meßwandler zur Detektion des Sauerstoffgehaltes in Gasen zu schaffen, mit dem die angegebenen Nachteile des Standes der Technik überwunden werden können.

Dies wird mit dem Verfahren nach Anspruch 1 erreicht. Ein vorteilhafter Meßwandler zur Durchführung des erfindungsgemäßen Verfahrens sowie ein geeignetes Herstellungsverfahren sind Gegenstand weiterer Patentansprüche.

Gemäß dem erfindungsgemäßen Verfahren wird ein schicht- oder folienartiger Funktionswerkstoff aus einem halbleitenden Metalloxid, dessen Thermokraft sich als Funktion des Sauerstoffpartialdruck darstellen läßt, mit dem zu analysierenden Gas beaufschlagt. Außerdem wird zwischen zwei Stellen des Funktionswerkstoffs eine Temperaturdifferenz erzeugt. Die Spannungsdifferenz zwischen den beiden auf unterschiedlichen Temperaturen befindlichen Stellen des Funktionswerkstoffs wird gemessen. Sie hängt von der Thermokraft des Funktionswerkstoffs ab und ist ein Maß für den Sauerstoffkonzentration in dem zu analysierenden Gas. Die Spannungsdifferenz wird im folgenden auch als Ausgangssignal des Meßwandlers bezeichnet.

In einer bevorzugten Ausführung wird zusätzlich die Temperaturdifferenz zwischen den beiden auf unterschiedlichen Temperaturen befindlichen Stellen der Funktionsschicht mittels geeigneter Temperaturmeßmethoden bestimmt, oder auf andere Art ein Maß für die Temperaturdifferenz zwischen den beiden Spannungsanschlüssen gefunden.

Eine weitere Ausführung der Erfindung berücksichtigt zusätzlich die Temperatur der Funktionsschicht.

Wird der Meßwandler oberhalb einer Temperatur betrieben, ab der die Thermokraft der Funktionsschicht eine Funktion des Sauerstoffpartialdruckes der Umgebungsatmosphäre ist, so kann aus dem Sensorausgangssignal ggf. unter Berücksichtigung der Temperaturdifferenz zwischen den beiden auf unterschiedlichen Temperaturen befindlichen Stellen der Funktionsschicht auf den Sauerstoffgehalt des den Sensor umgebenden Gases geschlossen werden.

Das erfindungsgemäße Verfahren sowie der erfindungsgemäße Meßwandler können insbesondere eingesetzt werden:

- um den Sauerstoffgehalt von Abgasen aus Feuerungsanlagen (Kraftwerke, Hausbrand) zu bestimmen;
- um den Sauerstoffgehalt von Abgasen aus Verbrennungskraftmaschinen, z.B. Otto- oder Dieselmotor, zu bestimmen;
- im medizinischen Bereich, um den Sauerstoffgehalt ausgeatmeter Atemluft zu detektieren.

Im Folgenden wird die Erfindung anhand von Ausführungsbeispielen und Zeichnungen beschrieben. Es zeigen:

Fig. 1    den typischen Verlauf der Thermokraft $\eta$ über dem Logarithmus des Sauerstoffpartialdruckes $pO_2$ eines halbleitenden Metalloxides. Die Punkte r und l kennzeichnen die Wendepunkte der Kurve, der Punkt s den Nulldurchgang. Die Maßeinheit für die Thermokraft $\eta$ beträgt $\mu V/K$;

Fig. 2    eine prinzipielle Meßanordnung, um die Thermokraft eines Metalloxides zu messen;

Fig. 3    eine prinzipielle Meßanordnung mit zwei Thermoelementen, um die Thermokraft eines Metalloxides zu messen;

Fig. 4    eine prinzipielle Meßanordnung mit zwei Widerstandsthermometern, um die Thermokraft eines Metalloxides zu messen;

Fig. 5    ein mögliches Auswerteverfahren, bei dem die Temperaturdifferenz über der Funktionsschicht variiert wird.

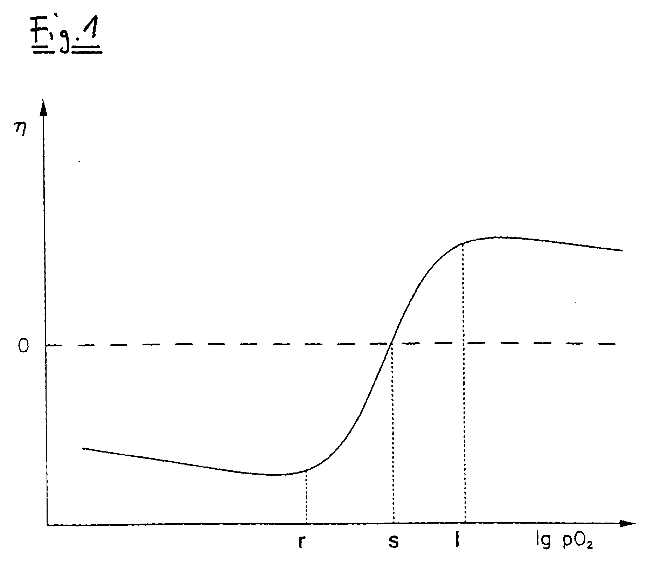

Der erfindungsgemäße Sensor nutzt die thermoelektrischen Eigenschaften von Metalloxiden aus. Die Thermokraft $\eta$ (in der Literatur auch Seebeck-Koeffizient genannt) von oxidischen Halbleitern weist prinzipiell den in Fig. 1 skizzierten Verlauf bei konstanter Temperatur auf. Die Kurve, insbesondere Punkte r,s,l verschieben sich mit der Temperatur. Eine ausführliche Beschreibung der Thermokrafteigenschaften von metalloxidischen Verbindungen findet man z.B. in [9]. Danach liegt links vom Punkt s Elektronenleitung aufgrund eines Sauerstoffdefizites, die zu negativer Thermokraft führt, vor, und rechts vom Punkt s liegt Defektelektronenleitung (Löcherleitung) aufgrund eines Sauerstoffüberschusses vor.

Die geometrischen Angaben der folgenden Beschreibung beziehen sich auf Fig. 2. Herrscht an einer Stelle der Funktionsschicht FS eine Temperatur $T_1$ und an einer anderen Stelle der Funktionsschicht FS die Temperatur $T_2$, so kann zwischen den beiden Stellen, die thermoelektrische Spannung $U_F$.

$$U_F = \int_{T_1}^{T_2} \eta(T, pO_2)\, dT \qquad\qquad (1)$$

gemessen werden. Im Falle kleiner Temperaturdifferenzen $T_2-T_1$ gilt näherungsweise

$$U_F \approx \eta(T, pO_2) \times (T_2 - T_1) \qquad\qquad (2)$$

Bei konstanter Temperaturdifferenz $T_2-T_1$ ist somit $U_F$ ein Maß für die Thermokraft $\eta(T, pO_2)$. Aufgrund des bekannten Zusammenhangs zwischen Thermokraft und Sauerstoffpartialdruck kann auf den Sauerstoffpartialdruck geschlossen werden. Durch Messung der Temperatur T kann die Temperaturabhängigkeit der sauerstoffpartialdruckabhängigen Thermokraft kompensiert wird.

Falls zusätzlich die Temperaturdifferenz $T_2-T_1$ bekannt sind, kann aus $U_F$ die Thermokraft $\eta(T, pO_2)$ und daraus der Sauerstoffpartialdruck berechnet werden. Anstatt direkt die Temperautrdifferenz $T_2-T_1$ zu messen, ist es selbstverständlich auch möglich, die Temperaturen $T_2$ und $T_1$ einzeln zu messen, und dann mit Hilfe von $U_F$ die Thermokraft $\eta(T, pO_2)$ und daraus den Sauerstoffpartialdruck zu berechnen.

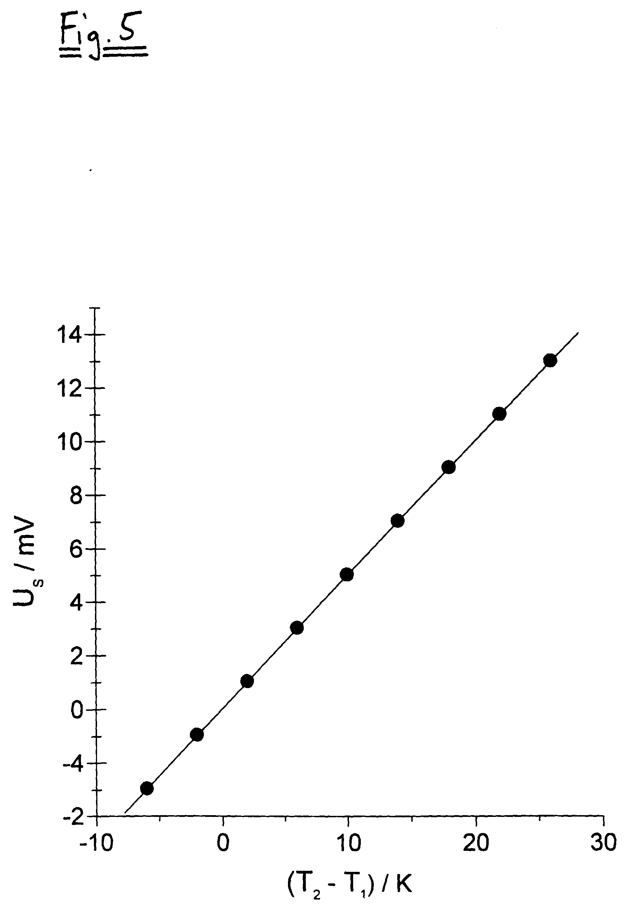

Eine einfache Messung kann mit einer Anordnung, wie in Fig. 3 skizziert, wie folgt durchgeführt werden: An der Funktionsschicht FS wird eine Temperaturdifferenz $T_2-T_1$ eingestellt, die mit Hilfe der Thermoelementpaare (in Fig. 3 beispielhaft Pt-Pt10%Rh) gemessen wird. Zusätzlich wird an den Kontaktstellen, die sich auf der Temperatur $T_U$ befinden, die Spannung $U_S$ gemessen, die sich im Prinzip aus der Summe der Spannung $U_F$ und aus einer Thermospannung $U_T$, die aus der Temperaturdifferenz zwischen $T_1$ und $T_U$ bzw. $T_2$ und $T_U$ resultiert, zusammensetzt. Da die Thermokraft von Platin bekannt ist, kann $U_T$ berechnet werden. Eine mögliche Form der Messung kann aber auch sein, die Temperaturdifferenz $T_2-T_1$ ständig zu variieren, wobei der Mittelwert aus $T_2$ und $T_1$ sich dabei nicht stark verändern sollte, und dabei $T_2-T_1$ und $U_S$ zu protokollieren. Es ergibt sich im Auftrag $U_S(T_2-T_1)$ eine Gerade (dargestellt in Fig. 5), deren Steigung die gesuchte Thermokraft $\eta$ ist. Evtl. vorhandene Offsetspannungen, wie z.B. o.g. Thermospannung des Platins gehen dabei in den Achsenabschnitt der Gerade $U_S(T_2-T_1)$ und nicht in die Steigung ein.

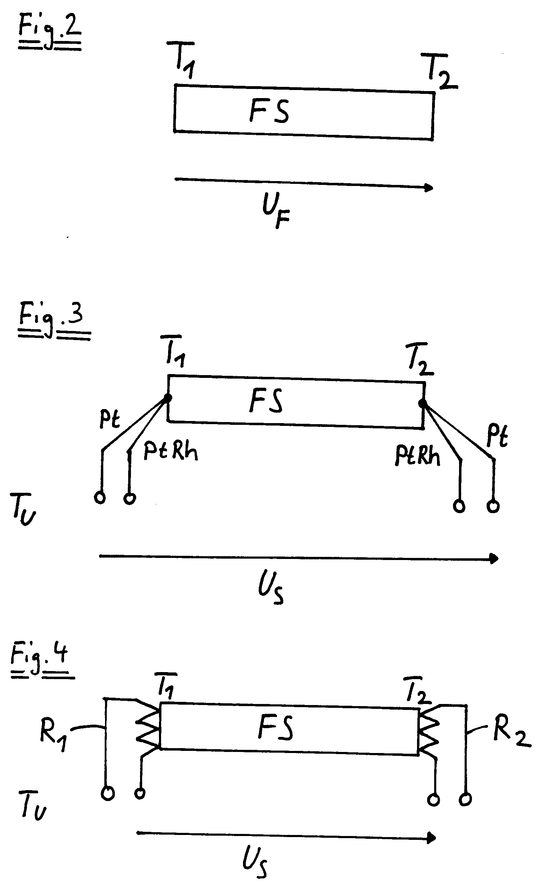

Eine weitere einfache Messung kann mit einer Anordnung, wie in Fig. 4 skizziert, wie folgt durchgeführt werden: An der Funktionsschicht FS wird eine Temperaturdifferenz $T_2-T_1$ eingestellt, die mit Hilfe der beiden Widerstandsthermometer R1,R2 (in Fig. 4 beispielhaft aus Platin) gemessen wird. Zusätzlich wird an den Kontaktstellen, die sich auf der Temperatur $T_U$ befinden, die Spannung $U_S$ gemessen, die sich im Prinzip aus der Summe der Spannung $U_F$ und aus einer Thermospannung $U_T$, die aus der Temperaturdifferenz zwischen $T_1$ und $T_U$ bzw. $T_2$ und $T_U$ resultiert, zusammensetzt. Da die Thermokraft von Platin bekannt ist, kann $U_T$ berechnet werden. Eine mögliche Form der Messung kann aber auch sein, die Temperaturdifferenz $T_2-T_1$ ständig zu variieren, wobei der Mittelwert aus $T_2$ und $T_1$ sich dabei nicht stark verändern sollte, und dabei $T_2-T_1$ und $U_S$ zu protokollieren. Es ergibt sich im Auftrag $U_S(T_2-T_1)$ eine Gerade, deren Steigung die gesuchte Thermokraft $\eta$ ist. Evtl. vorhandene Offsetspannungen, wie z.B. o.g. Thermospannung des Platins, gehen dabei in den Achsenabschnitt der Gerade $U_S(T_2-T_1)$ und nicht in die Steigung ein.

Im folgenden wird ein typischer Aufbau in Schichttechnik beschrieben. Auf ein elektrisch nichtleitendes Substrat wird eine mit einer Temperaturmeßeinrichtung gem. Fig. 2 oder Fig. 3 versehene Funktionsschicht aufgebracht. Auf der anderen Flachseite des Substrates wird eine Heizungsschicht aufgebracht. Auf die Funktionsschicht werden in Dickschichttechnik oder Dünnschichttechnik Elektroden für den Spannungsabgriff aufgebracht. Sowohl Heizungs- als auch Elektroden- und Funktionsschicht können in Dickschichttechnik und/oder in Dünnschichttechnik realisiert werden. Es ist aber auch möglich, aus dem Material der Funktionsschicht eine Folie zu gießen und diese auf ein mit einer Temperaturmeßeinrichtung gem. Fig. 2 oder Fig. 3 versehenes Substrat aufzubringen.

Die Funktionsschicht kann insbesondere aus einem dotierten Mehrfachmetalloxid, bevorzugt auf Titanatbasis oder Ferratbasis, bestehen.

Es wird darauf hingewiesen, daß der erfindungsgemäße Meßwandler nicht notwendigerweise eine Heizung aufweisen muß. Die Erzeugung der Temperaturdifferenz innerhalb der Funktionsschicht kann auch durch andere Maßnahmen erreicht werden. So ist es zum Beispiel beim Einsatz des Sensors innerhalb des Abgasstrangs eines Verbrennungsmotors möglich, die Temperierung der Funktionsschicht mittels der heißen Motorabgase zu realisieren.

Es ist auch möglich, die Temperatur-Meßwiderstände für Heizzwecke zu benutzen. Es können auch Teile der Heizung als Elektrode für den Spannungsabgriff an den auf unterschiedlichen Temperaturen befindlichen Stellen der Funktionsschicht geschaltet werden.

## EP 1 003 030 A2

**In der Anmeldung zitierte Literatur zum Stand der Technik:**

[1] Kleitz M., Siebert E., Fabry P., Fouletier J.: Solid-State Electrochemical Sensors. In: Sensors. A comprehensive Survey. Chemical and Biochemical Sensors Part I. Göpel W. et al. (Hrsg.), VCH-Verlag, Weinheim, 1991, Seite 341-428.

[2] Howarth D.S., Micheli A. L.: A simple titania thick film exhaust gas oxygen sensor. SAE 840140, 1984.

[3] Schönauer U.: Strontiumtitanat-Sauerstoffsensoren in Dickschichttechnologie. Dissertation, Karlsruhe 1990.

[4] Gerblinger J.: Sauerstoffsensoren auf der Basis gesputterter Strontiumtitanat Schichten. Dissertation, Karlsruhe 1991.

[5] Schönauer U.: Dickschicht Sauerstoffsensoren auf der Basis keramischer Halbleiter. Technisches Messen $\underline{56}$ [6] 260-263, 1989.

[6] Blase R.: Temperaturunabhängige Sauerstoffsensoren mit kurzer Einstellzeit auf der Basis von $La_2CuO_{4+\delta}$-Dickschichten. Dissertation, Karlsruhe 1996.

[7] Ruhland B., Becker T., Müller G.: Gas-kinetic interactions of nitrous oxides with SnO2 surfaces. Sensors and Actuators B $\underline{50}$ 85-94, 1998.

[8] Mosley P.T.: Solid State Gas Sensors. Meas. Sci. Technol. $\underline{8}$ 223-237, 1997.

[9] Joffe A.F.: Physik der Halbleiter, Berlin 1958.

**Patentansprüche**

1. Verfahren zur Detektion der Sauerstoffkonzentration in einem Gas, wobei

   - ein schicht- oder folienartiger Funktionswerkstoff aus einem halbleitenden Metalloxid, dessen Thermokraft sich als Funktion des Sauerstoffpartialdrucks darstellen läßt, mit dem zu analysierenden Gas beaufschlagt wird;
   - zwischen zwei Stellen des Funktionswerkstoffs eine Temperaturdifferenz erzeugt wird;
   - die Spannungsdifferenz zwischen den beiden auf unterschiedlichen Temperaturen befindlichen Stellen des Funktionswerkstoffs gemessen wird, welche ein Maß für die Sauerstoffkonzentration darstellt.

2. Verfahren nach Anspruch 1, dadurch gekennzeichnet, daß die Temperaturdifferenz zwischen den beiden auf unterschiedlichen Temperaturen befindlichen Stellen des Funktionswerkstoffs direkt gemessen wird und in die Bestimmung der Sauerstoffkonzentration mit einbezogen wird.

3. Verfahren nach Anspruch 2, dadurch gekennzeichnet, daß zusätzlich die Temperatur mindestens einer der beiden auf unterschiedlichen Temperaturen befindlichen Stellen gemessen werden.

4. Verfahren nach Anspruch 1, dadurch gekennzeichnet, daß die Temperaturen der beiden auf unterschiedlichen Temperaturen befindlichen Stellen des Funktionswerkstoffs separat gemessen werden, und in die Bestimmung der Sauerstoffkonzentration mit einbezogen wird.

5. Verfahren nach Anspruch 3 oder 4, dadurch gekennzeichnet, daß mittels mindestens einer der ermittelten Temperaturen die Temperaturabhängigkeit der sauerstoffpartialdruckabhängigen Thermokraft kompensiert wird.

6. Verfahren nach einem der vorangehenden Ansprüche, dadurch gekennzeichnet, daß die Temperaturmessungen mittels Thermoelementen und/oder Widerstandsthermometern erfolgen.

7. Verfahren nach einem der vorangehenden Ansprüche, dadurch gekennzeichnet, daß die Temperaturdifferenz zwischen den auf unterschiedlichen Temperaturen befindlichen Stellen des Funktionswerkstoffs mittels einer schicht- oder folienartigen Heizung erzeugt wird.

8. Verfahren nach Anspruch 7, dadurch gekennzeichnet, daß Teile der Heizung als Elektrode für den Spannungsabgriff an den auf unterschiedlichen Temperaturen befindlichen Stellen der Funktionsschicht geschaltet werden.

9. Verfahren nach Anspruch 7, dadurch gekennzeichnet, daß Teile der Heizung zur Temperaturmessung eingesetzt werden.

10. Verfahren nach einem der vorangehenden Ansprüche, dadurch gekennzeichnet, daß die Spannungsdifferenz zwischen den beiden auf unterschiedlichen Temperaturen befindlichen Stellen des Funktionswerkstoffs einschließlich eventueller Offset-Spannungen, z.B. Thermospannungen an den Kontakten der Spannungsmeßgeräte, gemessen wird, wobei die Messung bei mehreren Temperaturdifferenzen durchgeführt wird, und aus den so erhaltenen Meßwerten ein Maß für die Sauerstoffkonzentration ermittelt wird.

11. Verfahren nach einem der vorangehenden Ansprüche, dadurch gekennzeichnet, daß es sich bei dem halbleitenden Metalloxid der Funktionsschicht um ein dotiertes Metalloxid handelt.

12. Verfahren nach Anspruch 111, dadurch gekennzeichnet, daß es sich bei dem halbleitenden Metalloxid der Funktionsschicht um ein dotiertes Mehrfachmetalloxid handelt.

13. Verfahren nach einem der Ansprüche 11 oder 12, dadurch gekennzeichnet, daß es sich bei dem halbleitenden Metalloxid der Funktionsschicht um ein dotiertes Mehrfachmetalloxid auf Titanatbasis oder Ferratbasis handelt.

14. Meßwandler zur Durchführung des Verfahrens nach einem der vorangehenden Ansprüche, gekennzeichnet durch

- ein elektrisch nichtleitendes Substrat,
- ein auf einer Flachseite des Substrats angeordneter schicht- oder folienartiger Funktionswerkstoff aus einem haltleitenden Metalloxid, dessen Thermokraft sich als Funktion des Sauerstoffpartialdrucks darstellen läßt,
- eine auf der anderen Flachseite des Substrats angeordnete schicht- oder folienartige elektrische Heizung, mit der zwischen zwei Stellen des Funktionswerkstoffs eine Temperaturdifferenz erzeugt werden kann;
- zwei an den beiden für unterschiedliche Temperaturen vorgesehenen Stellen des Funktionswerkstoffs angeordneten Elektroden,
- Mittel zur Ermittlung der Temperatur an den beiden oder der Temperaturdifferenz zwischen den beiden für unterschiedliche Temperaturen vorgesehenen Stellen des Funktionswerkstoffs,
- Mittel zur Ermittlung der Spannungsdifferenz zwischen den beiden auf unterschiedlichen Temperaturen befindlichen Stellen des Funktionswerkstoffs.

15. Verfahren zur Herstellung eines Meßwandlers nach Anspruch 14, dadurch gekennzeichnet, daß

- auf die eine Flachseite des elektrisch nichtleitenden Substrats die elektrische Heizung in Dickschichttechnik oder Dünnschichttechnik aufgebracht wird,
- auf die andere Flachseite des Substrats der Funktionswerkstoff aufgebracht wird,
- an den beiden für unterschiedliche Temperaturen vorgesehenen Stellen des Funktionswerkstoffs die Elektroden in Dickschichttechnik oder Dünnschichttechnik aufgebracht werden,
- an den beiden für unterschiedliche Temperaturen vorgesehenen Stellen des Funktionswerkstoffs Thermoelemente und/oder Widerstandshermometer zur Ermittlung der Temperaturen oder Temperaturdifferenz in Dickschichttechnik oder Dünnschichttechnik aufgebracht werden.

## Fig. 1

Fig.2

$T_1$ $T_2$

FS

$U_F$

Fig.3

$T_1$ $T_2$

FS

Pt

PtRh

PtRh

Pt

$T_U$

$U_S$

Fig.4

$T_1$ $T_2$

FS

$R_1$

$R_2$

$T_U$

$U_S$

## Fig. 5